# EUROPÄISCHE PATENTSCHRIFT

(11) **EP 0 378 729 B1**
(45) Veröffentlichungstag und Bekanntmachung des Hinweises auf die Patenterteilung: **03.11.1993**
(21) Anmeldenummer: 89100970.6
(22) Anmeldetag: 20.01.1989
(51) Int. Cl.: H03B 11/10, H03B 5/32

(54) **Oszillatorschaltung**
Oscillator circuit
Circuit oscillateur

(43) Veröffentlichungstag der Anmeldung: 25.07.1990
(73) Patentinhaber: Siemens-Elema AB, 171 95 Solna 1 (SE); SIEMENS AKTIENGESELLSCHAFT, 80333 München (DE)
(72) Erfinder: Strandberg, Hans-Gustaf, Dipl.-Ing., S-172 36 Sundbyberg (SE)

(56) Entgegenhaltungen:
- DE-A- 2 603 543
- GB-A- 2 005 944
- US-A- 4 117 421
- US-A- 4 743 789
- IEEE JOURNAL OF SOLID-STATE CIRCUITS, Band SC-19, Nr. 2, April 1984, Seiten 228-236, IEEE; J.T. SANTOS et al.: "A one-pin crystal oscillator for VLSI circuits"

## Beschreibung

Die Erfindung betrifft eine Oszillatorschaltung zu Erzeugung eines eine periodische Schwingung ausführenden Ausgangssignales, wobei ein Quarz mit seinen Anschlüssen mit der Oszillatorschaltung verbindbar ist.

Derartige Oszillatorschaltungen sind in den unterschiedlichsten Ausführungsformen im Gebrauch. Allen Ausführungsformen gemeinsam ist, dass Massnahmen getroffen sind, die dazu dienen, die während der mechanischen Schwingung des Quarzes auftretenden geringen Energieverluste zu kompensieren.

Bei den bekannten Ausführungsformen geschieht dies in der Regel dadurch, dass das der mechanischen Schwingung des Quarzes entsprechende elektrische Signal abgegriffen und über eine Verstärkerschaltung, die dem Signal eine geeignete Phasenverschiebung erteilt, dem Quarz wieder zugeführt wird. Es handelt sich hierbei um eine sogenannte lineare Lösung des Problems, da die Schwingung des Quarzes durch eine Energiezufuhr aufrechterhalten wird, die in geeignete Phasenbeziehung zu der Schwingung des Quarzes erfolgt. Auf diese Weise wird dem Quarz zwar die erforderliche Energie zugeführt; auf Grund von Phasenfehlern und insbesondere der niedrigen Ausgangsimpedanz der Verstärkerschaltung erfolgt hier jedoch zugleich wieder eine Bedämpfung der Schwingung, die durch eine entsprechend erhöhte Energiezufuhr ausgeglichen werden muss. Die bekannten Oszillatorschaltungen besitzen somit einen geringen Wirkungsgrad, so dass sie für Anwendungsfälle, wo ein möglichst geringer Stromverbrauch ein wesentliches Kriterium darstellt, dies ist z.B. im Falle von implantierbaren medizinischen Geräten wie Herzschrittmachern und dergleichen der Fall, weniger geeignet sind.

Ein weiterer Nachteil der meisten bekannten Oszillatorschaltungen liegt darin, dass diese Schaltungen dann, wenn sie als integrierte Schaltungen ausgeführt werden, zwei besondere Anschluss-Pins für den Quarz aufweisen müssen. Da jedes zusätzliche Anschluss-Pin den Platzbedarf der integrierten Schaltung vergrössert, wäre es wünschenswert, über Oszillatorschaltungen verfügen zu können, bei denen nur ein spezielles Anschluss-Pin für den Quarz benötigt wird. Derartige Schaltungen sind zwar bereits bekannt (Joseph T. Santos et al.: "A One-Pin Crystal Oscillator for VLSI Circuits", IEEE Journal of Solid State Circuits, volume SC-19, No. 2, April 1984, Seiten 228 bis 235), jedoch besteht die Gefahr, dass solche Oszillatorschaltungen nicht mit der Grundfrequenz des Quarzes, sondern mit einer Harmonischen schwingen, was aus verständlichen Gründen unerwünscht ist.

Der Erfindung liegt die Aufgabe zugrunde, eine Oszillatorschaltung der eingangs genannten Art so auszubilden, dass sie einen hohen Wirkungsgrad aufweist und die Voraussetzungen dafür geschaffen sind, dass zum Anschluss des Quarzes nur ein spezielles Anschluss-Pin benötigt wird.

Nach der Erfindung wird diese Aufgabe durch eine Oszillatorschaltung mit einer Schaltstufe, einer Ansteuerschaltung und zwei an eine Stromversorgung anschliessbaren Versorgungsleitungen gelöst, wobei ein Quarz mit seinem einen Anschluss direkt mit dem Ausgang der Schaltstufe und mit seinem anderen Anschluss direkt mit einer ein Bezugspotential führenden Leitung verbunden ist und die Ansteuerschaltung, die einen mit dem Ausgang der Schaltstufe verbundenen Eingang aufweist, die Schaltstufe derart ansteuert, dass der Ausgang der Schaltstufe bei angesteuerter Schaltstufe kurzzeitig gegenüber der Halbperiode der Schwingung an die in ihre Polarität der jeweiligen Halbperiode der Schwingung entsprechende Versorgungsleitung angeschaltet ist. Im Falle der erfindungsgemässen Oszillatorschaltung erfolgt eine Energiezufuhr für den Quarz also nicht kontinuierlich, sondern während einer Halbperiode jeweils nur kurzzeitig. Dies hat zur Folge, dass die Schaltstufe den Quarz praktisch nicht belastet. Zwar besitzt die Schaltstufe im angesteuerten Zustand eine geringe Ausgangsimpedanz, jedoch ist diese nur kurzzeitig, nämlich während der Ansteuerung, wirksam. Im Gegensatz zum Stand der Technik, wo die geringe Ausgangsimpedanz der Verstärkerschaltung während der gesamten Halbperiode dämpfend wirkt, wird also ein deutlich erhöhter Wirkungsgrad erzielt. Infolge der nicht kontinuierlich, sondern impulsartig erfolgenden Energiezufuhr entfallen auch Phasenprobleme, da lediglich sichergestellt sein muss, dass der Ausgang an die Versorgungsleitung mit der der jeweiligen Halbperiode der Schwingung des Quarzes entsprechende Polarität angeschaltet ist. Da der an die Oszillatorschaltung angeschlossene Quarz mit seinem einen Anschluss mit einer auf ein Bezugspotential, z.B. Masspotential, legbaren Leitung verbunden ist, ist nur ein spezielles Anschluss-Pin für den Quarz erforderlich, falls die Oszillatorschaltung als integrierte Schaltung ausgeführt wird. Dabei ist die Gefahr, dass der Quarz nicht seine Grundschwingung ausführt, sondern zu einer Schwingung mit einer seine Harmonischen angeregt wird, vermieden, da der Quarz völlig frei schwingt, wenn man von den kurzen Momenten der Energiezufuhr absieht.

Eine sehr hohe Funktionssicherheit der Schaltung wird erreicht, wenn die Ansteuerschaltung die Schaltstufe während aufeinanderfolgender Halbperioden der Schwingung ansteuert, was bedeutet, dass die Ansteuerung während verschiedenartiger Halbperioden der Schwingung erfolgt. Es ist im Rahmen der Erfindung jedoch auch möglich, dass die Ansteuerschaltung die Schaltstufe jeweils nur während gleichartiger Halbperioden der Schwingung ansteuert.

Eine Ausführungsform der Erfindung sieht vor, dass als ein Bezugspotential führende Leitung eine der Versorgungsleitungen vorgesehen ist. Dies ist insbesondere dann zweckmässig, wenn eine unipolare Stromversorgung, z.B. eine Batterie, vorgesehen ist.

Im Falle einer bevorzugten Ausführungsform der Erfindung ist vorgesehen, dass die Ansteuerschaltung eine Verzögerungsschaltung enthält, der das Ausgangssignal zugeführt ist, und dass das Ausgangssignal in zeitlicher Überlagerung mit dem verzögerten Signal die Schaltstufe ansteuert. Es können auf diese Weise also die zur Ansteuerung der Schaltstufe erforderliche Signale besonders einfach erzeugt werden. Da die Frequenzen, mit denen zur Verwendung in Oszillatorschaltungen vorgesehene Quarze schwingen, in der Regel im kHz-Bereich liegen, genügt es die Schaltstufe für eine Dauer anzusteuern, die in der Grössenordnung von Mikrosekunden liegt. Eine entsprechende Verzögerung des Ausgangssignales ist auf äusserst einfache Weise erreichbar, wenn gemäss einer Variante der Erfindung als Verzögerungsschaltung eine Reihenschaltung mehrere Logikgatter vorgesehen ist.

Eine weitere besonders vorteilhafte Ausführungsform der Erfindung sieht vor, dass die Ansteuerschaltung eine Eingangsstufe aufweist, die das Ausgangssignal in ein Rechtecksignal umsetzt, dessen Impuls-Pausen-Verhältnis von dem Pegel des Ausgangssignals abhängt. In diesem Falle verlagert sich bei fallendem Pegel des Ausgangssignals der Zeitpunkt, zu dem die Ansteuerung der Schaltstufe erfolgt, von dem Beginn der jeweiligen Halbperiode zu einem späteren Zeitpunkt während der Halbperiode. Da aber die impulsartige Energiezufuhr um so wirkungsvoller ist, je näher sie bei dem Amplitudenmaximum der jeweiligen Halbperiode der Schwingung erfolgt - am effektivsten ist die Energiezufuhr während des Amplitudenmaximums - werden lastabhängige Pegelschwankungen des Ausgangssignals selbsttätig ausgeglichen.

Als Schaltstufe ist gemäss einer Ausführungsform der Erfindung eine die beiden Versorgungsleitungen verbindende Reihenschaltung von vier Halbleiterschaltern vorgesehen, wobei der Verbindungspunkt der beiden mittleren Halbleiterschalter den Ausgang der Schaltstufe bildet und von den zwischen dem Ausgang der Schaltstufe und einer Versorgungsleitung jeweils befindlichen zwei Halbleiterschaltern einer mit dem Ausgangssignal und einer mit dem verzögerten Signal angesteuert wird. In diesem Falle erfolgt eine Energiezufuhr während aufeinanderfolgender Halbperioden der Schwingung. Ein besonders einfacher Aufbau der Schaltung, der insbesondere deren Ausführung als integrierte Schaltung erleichtert, ergibt sich, wenn die Ansteuerschaltung als Eingangsstufe einen Inverter und als Verzögerungsschaltung eine Serienschaltung einer ungeraden Anzahl von Invertern aufweist. Dies gilt für den Fall, dass die Schaltstufe invertierend wirkt. Für den Fall dass die Schaltstufe nicht invertierend wirkt, kann die Ansteuerschaltung als Eingangsstufe entweder einen Puffer oder eine Serienschaltung zweier Inverter aufweisen.

Die Erfindung wird nachfolgend an Hand der beigefügten Zeichnungen näher erläutert. Es zeigen:
- Fig. 1: in grob schematisierte Darstellung ein Prinzipschaltbild eines Oszillators gemäss der Erfindung,
- Fig. 2 bis 4: die Signalverläufe für verschiedene Punkte Schaltung gemäss Fig. 1,
- Fig. 5: eine weitgehend aus Standard-Logik-Bauelementen aufgebaute erfindungsgemässe Oszillatorschaltung, und
- Fig. 6: die einer als integrierte Schaltkreis ausgeführten erfindungsgemässen Oszillatorschaltung zugrundeliegende Schaltung in detaillierter Darstellung.

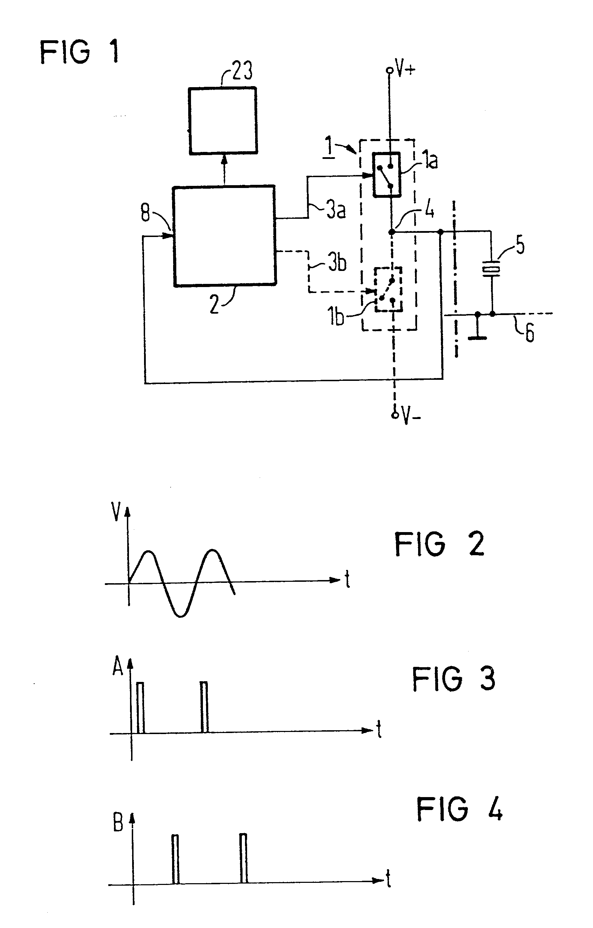

Gemäss Fig. 1 umfasst die erfindungsgemässe Oszillatorschaltung eine Schaltstufe 1, die aus zwei mittels eine Ansteuerschaltung 2 betätigbar Schaltern 1a und 1b gebildet ist. Dabei sind die Schalter 1a und 1b derart ausgeführt, dass sie dann schliessen, wenn ihnen von der Ansteuerschaltung 2 ein Signal über die Leitungen 3a bzw. 3b zugeführt wird. Die Schalter 1a und 1b sind in Serie geschaltet, und zwar derart, dass sie zwischen zwei mit V+ und V- bezeichneten, an eine nicht dargestellte Stromversorgung anschliessbaren Versorgungsleitungen liegen. Der Verbindungspunkt 4 der beiden Schalter 1a und 1b bildet den Ausgang der Schaltstufe 1. Mit dem Ausgang 4 der Schaltstufe 1 ist ein Quarz 5 mit seinem einen Anschluss wie in Fig. 1 dargestellt verbunden. Der andere Anschluss des Quarzes 5 ist wie in Fig. 1 dargestellt mit einer ein Bezugspotential führenden Leitung 6 verbunden, die im Falle der Fig. 1 an Masse liegt. Das Ausgangssignal der Oszillatorschaltung ist von dem Punkt 4 dem Eingang 8 der Ansteuerschaltung 2 zugeführt. Die Ansteuerschaltung 2 steuert die Schaltstufe 1 anhand des ihr zugeführten Ausgangssignals der Oszillatorschaltung derart an, dass der Ausgang 4 der Schaltstufe 1 bei angesteuerte Schaltstufe 1 kurzzeitig an die in ihrer Polarität der jeweiligen Halbperiode der Schwingung entsprechende Versorgungsleitung V+ bzw. V- angeschaltet ist. Ein zur Steuerung digitaler Schaltkreise 23 (schematisch angedeutet) geeignetes Signal, wird der Ansteuerschaltung 2 an hierfür geeigneter Stelle, z.B. nach einer Pufferstufe, entnommen.

Wie dies aus den Figuren 2 bis 4 deutlich wird, von denen Figur 2 das Signal V am Punkt 4, Fig. 3 das Signal A auf der Leitung 3a und Fig. 4 das Signal B auf der Leitung 3b in korrekter zeitlicher Zuordnung zueinander zeigen, gibt also die Ansteuerschaltung 2 während jeder positiven Halbperiode des Ausgangssignals einen kurzzeitigen Impuls über die Leitung 3a, und während jeder negativen Halbperiode des Ausgangssignals einen kurzzeitigen Impuls über die Leitung 3b ab. Jeder dieser Impulse schliesst während seiner Impulsdauer den entsprechenden Schalter 1a bzw. 1b, so dass während dieser Zeitdauer eine Energiezufuhr zu dem Quarz 5 stattfinden kann. Dabei erfolgt die Energiezufuhr während aufeinanderfolgender und damit verschiedenartiger Halbperioden der Schwingung.

Wie dies in Fig. 1 durch die strichlierte Darstellung des Schalters 1b, der Leitung 3b und der Versorgungsleitung V- angedeutet ist können diese Komponenten auch entfallen. Eine wie erwähnt nicht dargestellte Stromversorgung ist dann mit der Versorgungsleitung V+ und der das Bezugspotential führenden Leitung 6 zu verbinden. In diesem Falle erfolgt eine Energiezufuhr nur während gleichartiger, nämlich der jeweils positiven Halbperioden der Schwingung.

Unter der Voraussetzung, dass der Eingang 8 der Ansteuerschaltung 2 eine ausreichend hohe Eingangsimpedanz aufweist, wird also der Quarz 5 durch die Ansteuerschaltung 2 nicht nennenswert belastet. Auch die Schaltstufe 1, die im angesteuerten Zustand zwar eine niedrige Ausgangsimpedanz aufweist, aber nur kurzzeitig während einer Halbperiode angesteuert wird, belastet den Quarz 5 nicht nennenswert. Störenden Phasenverschiebungen können im Falle der erfindungsgemässen Oszillatorschaltung nicht auftreten, solange nur sichergestellt ist, dass der Ausgang 4 der angesteuerten Schaltstufe 1 tatsächlich an die ihre Polarität der jeweils vorliegenden Halbperiode der Schwingung entsprechende Versorgungsleitung V+ bzw. V- angeschaltet ist.

Bei nicht angesteuerte Schaltstufe 1 führt der Quarz 5 eine freie Schwingung aus, so dass die Gefahr, dass der Oszillator nicht mit der Grundfrequenz des Quarzes 5, sondern einer Harmonischen der Grundfrequenz schwingt, äusserst gering ist.

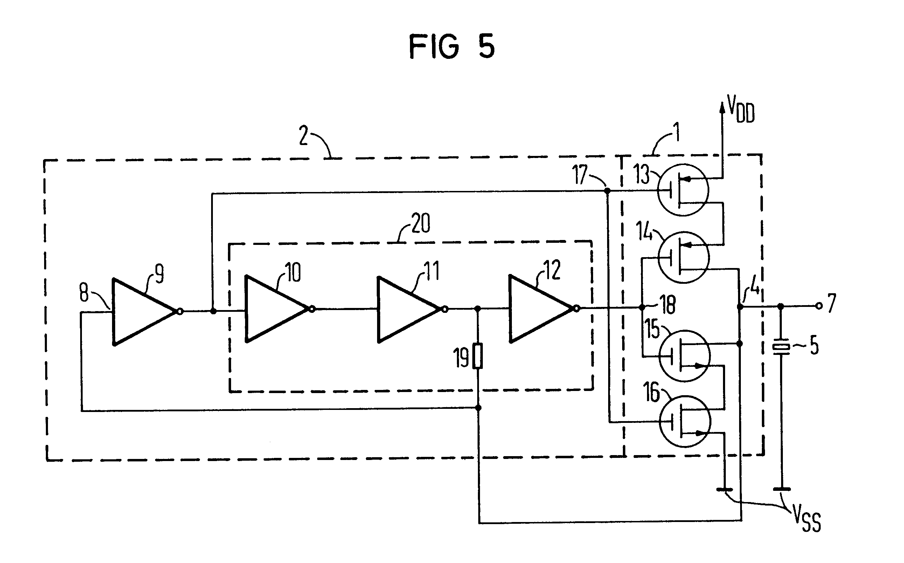

In Fig. 5 ist eine Oszillatorschaltung dargestellt, deren insgesamt mit 2 bezeichnete Ansteuerschaltung durch eine Reihenschaltung von vier Invertern 9, 10, 11, 12 gebildet ist. Als Schaltstufe 1 ist eine Serienschaltung von vier als Halbleiterschalter wirkenden MOS-Feldeffekttransistoren 13, 14, 15, 16 vorgesehen. Dabei handelt es sich bei den Feldeffekttransistoren 13 und 14 um P-Kanal-Typen und bei den Feldeffekttransistoren 15 und 16 um N-Kanal-Typen. Die Serienschaltung der Feldeffekttransistoren 13, 14, 15, 16 liegt mit den Source-Anschlüssen der Feldeffekttransistoren 13 und 16 zwischen den beiden Versorgungsleitungen V_{DD} und V_{SS}, die mit den Polen einer nicht dargestellten unipolaren Stromversorgung verbindbar sind. Die Gate-Anschlüsse der beiden Feldeffekttransistoren 13 und 16 sowie die der beiden Feldeffekttransistoren 14 und 15 sind jeweils miteinander verbunden. Die entsprechenden Knoten 17 und 18 sind mit dem Ausgang des Inverters 9 bzw. dem Ausgang des Inverters 12 verbunden. Die Verbindungsstelle der Drain-Anschlüsse der Feldeffekttransistoren 14 und 15 bildet den Ausgang 4 der Schaltstufe 1, der mit dem Eingang der Ansteuerschaltung 2, d.h. mit dem Eingang des Inverters 9, verbunden ist. Zwischen die Verbindungsleitung des Ausganges 4 der Schaltstufe 1 mit dem Eingang der Ansteuerschaltung 2 und die Verbindungsleitung des Ausgangs des Inverters 11 mit dem Eingang des Inverters 12 ist ein hochohmiger Widerstand 19 geschaltet, der dazu dient das Spannungsniveau am Ausgang 7 und am Eingang 8 so einstellen, dass die an den Ausgängen der Inverter 9 bis 12 auftretenden Rechtecksignale im wesentlichen das gleiche Impuls-Pausen-Verhältnis aufweisen.

Der Quarz 5 ist mit seinem einen Anschluss mit dem Ausgang 4 der Schaltstufe 1 und mit seinem anderen Anschluss mit der Versorgungsleitung V_{SS} verbunden, wobei letztere also zugleich das Bezugspotential führt.

Die Funktion der Schaltung gemäss Fig. 5 ist folgende:
Das Ausgangssignal der Oszillatorschaltung gelangt zu dem Inverter 9, der die Eingangsstufe der Ansteuerschaltung 2 darstellt. Das sinusförmige Ausgangssignal wird durch den Inverter 9 in ein Rechtecksignal, dessen Amplitude zwischen den Pegeln logisch 1 und logisch 0 wechselt, umgeformt und invertiert. Dieses Signal ist dem Knoten 17 und damit den Gate-Anschlüssen der Feldeffekttransistoren 13 und 16 zugeführt. Ausserdem durchläuft dieses Signal die Inverter 10 bis 12, wodurch es geringfügig verzögert und ausserdem invertiert wird. Die Inverter 10 bis 12 stellen also eine insgesamt mit 20 bezeichnete Verzögerungsschaltung dar, an deren Ausgang das Ausgangssignal des Inverters 9 in geringfügig verzögerte und invertierter Form erscheint. Dieses Signal ist dem Knoten 18 und damit den Gate-Anschlüssen der Feldeffekttransistoren 14 und 15 zugeführt. Während jeder positiven Halbperiode des Ausgangssignals liegen also die Knoten 17 und 18 kurzzeitig, nämlich für die Dauer der Verzögerungszeit, gleichzeitig auf dem Potential logisch 0, während sie während jeder negativen Halbperiode des Ausgangssignals für die Dauer der Verzögerungszeit gleichzeitig auf dem Potential logisch 1 liegen. Dies hat wiederum zur Folge, dass während jeder positiven Halbperiode des Ausgangssignals die Feldeffekttransistoren 13 und 14 und während jeder negativen Halbperiode des Ausgangssignals die Feldeffekttransistoren 15 und 16 kurzzeitig gleichzeitig aufgesteuert sind, so dass der Quarz 5 während jeder Halbperiode seiner Schwingung eine impulsartige Energiezufuhr geeigneter Polarität erfährt.

Da der Inverter 9 seinen Ausgangszustand jedesmal erst dann ändert, wenn das ihm zugeführte Ausgangssignal einen bestimmten Schwellwert über- bzw. unterschreitet, hängt der Zeitpunkt, zu dem die Schaltstufe 1 während einer Halbperiode jeweils angesteuert wird, von dem Pegel des Ausgangssignals ab. Da andererseits die impulsartige Energiezufuhr am wirkungsvollstens ist, wenn sie zu dem Zeitpunkt erfolgt, zu dem die Amplitude des Ausgangssignals während der jeweiligen Halbperiode ihren Extremwert erreicht, wird ein beginnender Pegelabfall des Ausgangssignals jeweils bereits während der nächsten Halbperiode der Schwingung dadurch kompensiert, dass die Energiezufuhr zu einem etwas späteren, näher bei dem Amplitudenmaximum der jeweiligen Halbperiode liegenden Zeitpunkt erfolgt und damit wirkungsvoller ist.

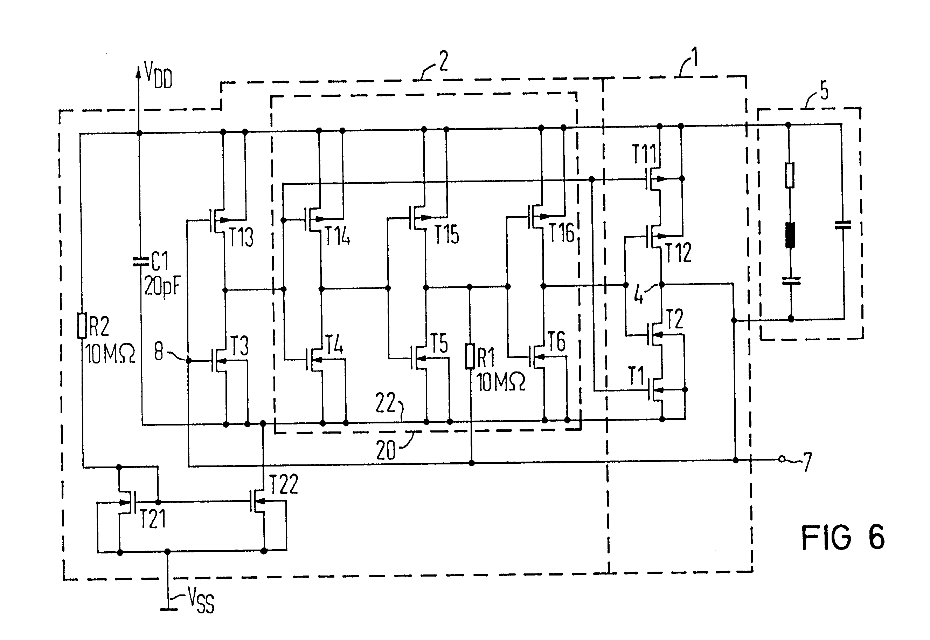

Die in der Fig. 6 detailliert dargestellte Schaltung entspricht im wesentlichen der Schaltung gemäss Fig. 5, mit dem Unterschied, dass als diejenige Leitung, die das Bezugspotential führt, die Versorgungsleitung V_{DD} vorgesehen ist. Demgemäss ist im Falle der Schaltung gemäss Fig. 6 der Quarz 5 mit seinem einen Anschluss mit dem Ausgang 4 der Schaltstufe 1 und mit seinem anderen Anschluss mit der Versorgungsleitung V_{DD} verbindbar. Anstelle des Schaltsymboles für den Quarz 5 ist übrigens dessen Ersatzschaltbild dargestellt, dass einer RCL-Serienschaltung mit einer Parallellkapazität entspricht.

Die Schaltung gemäss Fig. 6 weist eine Ansteuerschaltung 2 auf, die wieder aus einer Serienschaltung von vier Invertern gebildet ist. Die einzelnen Inverter sind in an sich bekannter Weise jeweils aus einem Komplementärpaar von MOS-Feldeffekttransistoren gebildet, nämlich aus den Feldeffekttransistoren T3/T13, T4/T14, T5/T15 und T6/T16. Der aus den Feldeffekttransistoren T3/T13 gebildete Inverter stellt die Eingangsstufe der Ansteuerschaltung dar und entspricht dem Inverter 9 gemäss Fig. 5. Die aus den Feldeffekttransistoren T4/T14, T5/15 und T6/T16 gebildeten Inverter entsprechen den Invertern 10, 11 und 12 gemäss Fig. 5 und stellen die Verzögerungsschaltung 20 der Ansteuerschaltung 2 dar. Die aus den vier MOS-Feldeffekttransistoren T1, T2, T11 und T12 gebildete Schaltstufe 1 entspricht in ihrem Aufbau und hinsichtlich ihre Verbindungen mit der Ansteuerschaltung 2 im wesentlichen der im Zusammenhang mit der Fig. 5 beschriebenen Schaltstufe. Auch im Falle der Fig. 6 ist wieder der Eingang 8 der Ansteuerschaltung 2 mit dem Ausgang 4 der Schaltstufe 1 verbunden, wobei ein hochohmiger Widerstand R1 vorgesehen ist, der dem im Zusammenhang mit der Fig. 5 beschriebenen hochohmigen Widerstand 19 entspricht.

Die Source-Anschlüsse der Feldeffekttransistoren T3, T4, T5, T6 und T1 sind nicht direkt mit der Versorgungsleitung V_{SS}, sondern mit einer Leitung 22 verbunden. Eine aus den Feldeffekttransistoren T21 und T22 sowie dem hochohmigen Widerstand R2 gebildete Stromspiegel-Schaltung stellt sicher, dass der durch die Oszillatorschaltung von V_{DD} nach V_{SS} fliessende Strom, der durch den zwischen die Leitung 22 und die Versorgungsleitung V_{SS} geschalteten Feldeffekttransistor T22 fliessen muss, nicht denjenigen Strom übersteigt, der durch den Widerstand R2 fliesst. Diese Massnahme, die dazu dient, den Stromverbrauch der Schaltung in vorteilhafter Weise zu senken, hat zur Folge, dass durch die Feldeffekttransistoren T11 und T12 der Schaltstufe 1 bei entsprechende Ansteuerung ein grösserer Strom fliessen kann als durch die Feldeffekttransistoren T1 und T2, wenn diese angesteuert sind. Um hier Abhilfe zu schaffen, ist ein Kondensator C1 als Energiespeicher zwischen die Versorgungsleitung V_{DD} und die Leitung 22 geschaltet, so dass sichergestellt ist, dass während der nur kurzzeitigen Ansteuerung der Feldeffekttransistoren T1 und T2 ausreichend hohe Impulsströme fliessen können.

Sämtlichen beschriebenen Schaltungen ist gemeinsam, dass der Quarz 5 mit dem einen seiner beiden Anschlüsse mit einer ein Bezugspotential führenden Leitung verbindbar ist. Dies bedeutet, dass im Falle der Ausführung der erfindungsgemässen Oszillatorschaltung als integrierte Schaltkreis nur ein spezielles Anschluss-Pin für den Quarz 5 erforderlich ist, was im Hinblick darauf, dass der Bauraumbedarf eines integrierten Schaltkreises wesentlich von der Zahl der erforderlichen Anschluss-Pins abhängt, einen wesentlichen Vorteil darstellt.

### Bezugszeichenliste

- 1: Schaltstufe
- 1a, 1b: Schalter
- 2: Ansteuerschaltung
- 3a, 3b: Leitung
- 4: Ausgang
- 5: Quarz
- 6: Leitung
- 7: Ausgang
- 8: Eingang
- 9,10, 11, 12: Inverter
- 13, 14, 15, 16: Feldeffekttransistor
- 17, 18: Knoten
- 19: Widerstand
- 20: Verzögerungsschaltung
- 22: Leitung
- 23: digitaler Schaltkreis
- A, B: Signal auf Leitung 3a bzw. 3b
- C1: Kondensator
- R1, R2: Widerstand
- T1 bis T6: Feldeffekttransistor
- T11 bis T16: Feldeffekttransistor
- T21 bis T22: Feldeffekttransistor
- V+, V-, V_{DD}, V_{SS}: Versorgungsleitung
- V: Signal am Ausgang 4

## Patentansprüche

1. Oszillatorschaltung zur Erzeugung eines eine periodische Schwingung ausführenden Ausgangssignals mit einer Schaltstufe (1), einer Ansteuerschaltung (2) und zwei an eine Stromversorgung anschliessbaren Versorgungsleitungen (V+,V-; V_{DD}, V_{SS}), wobei ein Quarz (5) mit seinem einen Anschluss direkt mit dem Ausgang (4) der Schaltstufe (1) und mit seinem anderen Anschluss direkt mit einer ein Bezugspotential führenden Leitung (6, V_{DD}, V_{SS}) verbunden ist und die Ansteuerschaltung (2), die einen mit dem Ausgang (4) der Schaltstufe (1) verbundenen Eingang (8) aufweist, die Schaltstufe (1) derart ansteuert, dass der Ausgang (4) der Schaltstufe (1) bei angesteuerter Schaltstufe (1) kurzzeitig gegenüber der Halbperiode der Schwingung an die in ihrer Polarität der jeweiligen Halbperiode der Schwingung entsprechende Versorgungsleitung (V+,V-; V_{DD}, V_{SS}) angeschaltet ist.

2. Oszillatorschaltung nach Anspruch 1, **dadurch gekennzeichnet,** dass die Ansteuerschaltung (2) die Schaltstufe (1) während aufeinanderfolgender Halbperioden der Schwingung ansteuert.

3. Oszillatorschaltung nach Anspruch 1, **dadurch gekennzeichnet,** dass die Ansteuerschaltung (2) die schaltstufe (1) jeweils während gleichartiger Halbperioden der Schwingung ansteuert.

4. Oszillatorschaltung nach einem der Ansprüche 1 bis 3, **dadurch gekennzeichnet,** dass als ein Bezugspotential führende Leitung (V_{DD}, V_{SS}) eine der Versorgungsleitungen (V_{DD}, V_{SS}) vorgesehen ist.

5. Oszillatorschaltung nach einem der Ansprüche 1 bis 4, **dadurch gekennzeichnet**, dass die Ansteuerschaltung (2) eine Verzögerungsschaltung (20) enthält, der das Ausgangssignal zugeführt ist, und dass das Ausgangssignal in zeitlicher Überlagerung mit dem verzögerten Signal die Schaltstufe (1) ansteuert.

6. Oszillatorschaltung nach Anspruch 5, **dadurch gekennzeichnet**, dass als Verzögerungsschaltung (20) eine Serienschaltung mehrerer Logikgatter (10, 11, 12) vorgesehen ist.

7. Oszillatorschaltung nach Anspruch 5 oder 6, **dadurch gekennzeichnet**, dass die Ansteuerschaltung (2) eine Eingangsstufe (9,T3/T13) aufweist, die das Ausgangssignal in ein Rechtecksignal umsetzt, dessen Impuls-Pausen-Verhältnis von dem Pegel des Ausgangssignals abhängt.

8. Oszillatorschaltung nach einem der Ansprüche 5 bis 7, **dadurch gekennzeichnet**, dass als Schaltstufe (1) eine die beiden Versorgungsleitungen (V_{DD}, V_{SS}) verbindende Reihenschaltung von vier Halbleiterschaltern (13, 14, 15, 16; T1, T2, T11, T12). vorgesehen ist, wobei die Verbindung der mittleren Halbleiterschalter (14, 15; T2, T11) den Ausgang (4) der Schaltstufe (1) bildet und von den zwischen dem Ausgang (4) der Schaltstufe (1) und einer Versorgungsleitung (V_{DD}, V_{SS}) jeweils befindlichen zwei Halbleiterschaltern (13, 14 bzw. 15, 16; T1, T2 bzw. T11, T12) einer mit dem Ausgangssignal und einer mit dem verzögerten Signal angesteuert wird.

9. Oszillatorschaltung nach einem der Ansprüche 5 bis 9, **dadurch gekennzeichnet**, dass die Schaltstufe (1) invertierend wirkt und die Ansteuerschaltung (2) als Eingangsstufe einen Inverter (9;T3/T13) und als Verzögerungsschaltung (20) eine Serienschaltung einer ungeraden Anzahl von Invertern (10, 11, 12; T4/T14, T5/T15, T6/T16)aufweist.

10. Oszillatorschaltung nach einem der Ansprüche 1 bis 9, **gekennzeichnet durch** die Verwendung in einem implantierbaren medizinischen Gerät.

## Claims

1. Oscillator circuit for the generation of an output signal executing a periodic oscillation, having a switching stage (1), a drive circuit (2) and two supply lines (V+, V-; V_{DD}, V_{SS}), which can be connected to a power supply, a quartz component (5) being provided, one of the connections of which is directly connected to the output (4) of the switching stage (1) and the other connection of which is directly connected to a line (6, V_{DD}, V_{SS}) which conducts a reference potential, and the drive circuit (2), which exhibits an input (8) connected to the output (4) of the switching stage (1), driving the switching stage (1) in such a manner that when the switching stage (1) is driven the output (4) of the switching stage (1) is connected, for a time which is short in comparison with the semiperiod of the oscillation, to the supply line (V+, V-; V_{DD}, V_{SS}) which corresponds in its polarity to the respective semiperiod of the oscillation.

2. Oscillator circuit according to Claim 1, characterised in that the drive circuit (2) drives the switching stage (1) during successive semiperiods of the oscillation.

3. Oscillator circuit according to Claim 1, characterised in that the drive circuit (2) drives the switching stage (1) in each instance during semiperiods of the oscillation which are of the same type.

4. Oscillator circuit according to one of Claims 1 to 3, characterised in that one of the supply lines (V_{DD}, V_{SS}) is provided as line (V_{DD}, V_{SS}) which conducts a reference potential.

5. Oscillator circuit according to one of Claims 1 to 4, characterised in that the drive circuit (2) includes a delay circuit (20) to which the output signal is fed, and in that the output signal drives the switching stage (1) in temporal heterodyning with the delayed signal.

6. Oscillator circuit according to Claim 5, characterised in that a series circuit of a plurality of logic gates (10, 11, 12) is provided as delay circuit (20).

7. Oscillator circuit according to Claim 5 or 6, characterised in that the drive circuit (2) exhibits an input stage (9, T3/T13) which converts the output signal into a square-wave signal the duty ratio of which is dependent upon the level of the output signal.

8. Oscillator circuit according to one of Claims 5 to 7, characterised in that a series circuit of four semiconductor switches (13, 14, 15, 16; T1, T2, T11, T12), which series circuit connects the two supply lines (V_{DD}, V_{SS}), is provided as switching stage (1), the connection of the central semiconductor switches (14, 15; T2, T11) forming the output (4) of the switching stage (1) and of the two semiconductor switches (13, 14 or respectively 15, 16; T1, T2 or respectively T11, T12) situated in each instance between the output (4) of the switching stage (1) and a supply line (V_{DD}, V_{SS}) one is driven by the output signal and one is driven by the delayed signal.

9. Oscillator circuit according to one of Claims 5 to 9, characterised in that the switching stage (1) has an inverting action and the drive circuit (2) exhibits an inverter (9; T3/T13) as input stage and a series circuit of an odd number of inverters (10, 11, 12; T4/T14, T5/T15, T6/T16) as delay circuit (20).

10. Oscillator circuit according to one of Claims 1 to 9, characterised by use in an implantable medical apparatus.

## Revendications

1. Circuit oscillant pour créer un signal de sortie à oscillation périodique, comportant un étage de commutation (1), un circuit d'attaque (2) et deux conducteurs d'alimentation (V+, V- ; V_{DD}, V_{SS}) susceptibles d'être reliées à une alimentation, du type dans lequel un quartz (5) est relié, par l'une de ses bornes directement à la sortie (4) de l'étage de commutation (1), et par l'autre de ses bornes directement à un conducteur (6, V_{DD}, V_{SS}) qui est à un potentiel de référence, et du type dans lequel le circuit d'attaque (2) qui comporte une entrée (8) reliée à la sortie (4) de l'étage de commutation (1), commande l'étage de commutation (1) de telle sorte que la sortie (4) de l'étage de commutation (1) est reliée, lors de la commande de l'étage de commutation (1), et pour une courte durée par rapport à la demi-période de l'oscillation, à la ligne d'alimentation (V+, V- ; V_{DD}, V_{SS}) correspondant, dans sa polarité, à la demi-période respective de l'oscillation.

2. Circuit oscillant suivant la revendication 1, caractérisé en ce que le circuit d'attaque (2) commande l'étage de commutation (1) pendant des demi-périodes successives de l'oscillation.

3. Circuit oscillant suivant la revendication 1, caractérisé en ce que le circuit d'attaque (2) commande l'étage de commutation (1) pendant des demi-périodes de l'oscillation de même genre.

4. Circuit oscillant suivant l'une des revendications 1 à 3, caractérisé en ce qu'il est prévu, comme conducteur (V_{DD}, V_{SS}) porté au potentiel de référence, un des conducteurs d'alimentation (V_{DD}, V_{SS}).

5. Circuit oscillant suivant l'une des revendications 1 à 4, caractérisé en ce que le circuit d'attaque (2) comporte un circuit à retard (20) auquel est envoyé le signal de sortie, et que le signal de sortie commande l'étage de commutation (1) lors de la superposition temporelle avec le signal retardé.

6. Circuit oscillant suivant la revendication 5, caractérisé en ce qu'il est prévu comme circuit à retard (20) un circuit série de plusieurs portes logiques (10, 11, 12).

7. Circuit oscillant suivant la revendication 5 ou 6, caractérisé en ce que le circuit d'attaque (2) comporte un étage d'entrée (9, T3/T13) qui convertit le signal de sortie en un signal rectangulaire dont le taux d'impulsions dépend du niveau du signal de sortie.

8. Circuit oscillant suivant l'une des revendications 5 à 7, caractérisé en ce qu'il est prévu, comme étage de commutation (1), un circuit série reliant les deux lignes d'alimentation (V_{DD}, V_{SS}) et constitué de quatre commutateurs à semiconducteurs (13, 14, 15, 16 ; T1, T2, T11, T12), la liaison des commutateurs à semiconducteurs centraux (14, 15, T2, T11) formant la sortie (4) de l'étage de commutation (1), et, parmi les deux commutateurs a semiconducteurs (13, 14 ou 15, 16 ; T1, T2 ou T11, T12) se trouvant entre la sortie (4) de l'étage de commutation (1) et un conducteur d'alimentation (V_{DD}, V_{SS}), l'un est commandé par le signal de sortie et l'autre est commandé par le signal retardé.

9. Circuit oscillant suivant l'une des revendications 5 à 9, caractérisé en ce que l'étage de commutation (1) possède une action inverseuse et le circuit d'attaque (2) comporte, comme étage d'entrée, un inverseur (9 ; T3/T13), et comme circuit à retard (20), un circuit série à nombre d'inverseurs impair (10, 11, 12 ; T4/T14, T5/T15, T6/T16).

10. Circuit oscillant suivant l'une des revendications 1 à 9, caractérisé en ce qu'il est utilisé Ðans un appareil médical susceptible d'être implantée.
